# EUROPEAN PATENT SPECIFICATION

(11) **EP 1 137 326 B1**
(45) Date of publication and mention of the grant of the patent: **05.07.2006**
(21) Application number: 99954412.5
(22) Date of filing: 05.11.1999
(51) Int. Cl.: H05B 33/14, H05B 33/22, C09K 11/06

(54) **ORGANIC ELECTROLUMINESCENT ELEMENT**
ELEKTROLUMINISZIERENDES, ORGANISCHES ELEMENT
ELEMENT ELECTROLUMINESCENT ORGANIQUE

(30) Priority: 06.11.1998 JP 31664898; 03.06.1999 JP 15695399
(43) Date of publication of application: 26.09.2001
(73) Proprietor: Nippon Steel Chemical Co., Ltd., Tokyo 141-0031 (JP); Mori, Tatsuo, Nagoya-shi, Aichi-ken 454-0004 (JP); Mizutani, Teruyoshi, Nagoya-shi, Aichi-ken 464-0083 (JP)
(72) Inventor: MORI, Tatsuo, Nagoya-shi, Aichi-ken 454-0004 (JP); MIZUTANI, Teruyoshi, Nagoya-shi, Aichi-ken 464-0083 (JP); MIYAZAKI, Hiroshi, Research & Development Lab., Oaza Nakabaru, Tobata-ku, Kitakyushu (JP); YAMASHITA, Koichi, Res.& Dev.Lab. Nippon Steel, Kitakyushu-shi, Fukuoka-ken, 804-8503- (JP); TAKEDA, Toru, Research & Development Laborator., Oaza Nakabaru, Tobata-ku, Kitakyushu-shi (JP)
(74) Representative: Calamita, Roberto
(86) International application number: PCT/JP1999/006182
(87) International publication number: WO 2000/028790

(56) References cited:
- WO-A1-98/08360
- JP-A- 8 012 969
- JP-A- 9 268 284
- JP-A- 10 321 376

## Description

### Field of Technology

This invention relates to organic electroluminescent elements and, more particularly, to organic electroluminescent elements useful as thin-film electroluminescent elements in displays.

### Background Technology

Electroluminescent elements (hereinafter referred to as EL element) utilizing electroluminescence are plainly visible due to self-luminescence and also highly impact-resistant because of their being completely solid, and on account of these properties, they are drawing attention as luminescent elements in a variety of displays. These EL elements are divided into inorganic EL elements that are based on inorganic compounds and organic EL elements that are based on organic compounds. Since the applied voltage can be reduced sharply in the case of organic El elements, concentrated studies are being made to put organic EL elements to practical use as display elements of the next generation.

An organic EL element is composed of layers of organic compounds containing a luminescent layer and a pair of electrodes holding the layers of organic compounds in between; concretely, the basic structure is anode/luminescent layer/cathode and it may be modified by suitable addition of a hole injection layer and an electron injection layer to, for example, a structure of anode/hole injection layer/luminescent layer/cathode or a structure of anode/hole injection layer/luminescent layer/electron injection layer/cathode. The hole injection layer performs the function of transporting holes injected from the anode to the luminescent layer while the electron injection layer performs the function of transporting electrons injected from the cathode to the luminescent layer. It is known that the hole injection layer interposed between the luminescent layer and the anode allows injection of more holes into the luminescent layer in a lower electric field and, as the hole injection layer does not transport electrons, the electrons injected into the luminescent layer from the cathode or from the electron injection layer accumulate in the interface between the hole injection layer and the luminescent layer with the resultant increase in luminous efficiency.

Extensive studies in recent years, for example, those in Japan Kokai Tokkyo Koho Hei 3-35083 (1991) and Japan Kokai Tokkyo Koho Hei 3-54289 (1991), give a description of the use of a material derived from styrylsubstituted triphenylamine such as 4-(2,2-diphenylethenyl)-N,N-diphenylbenzenamine as a luminescent material in the luminescent layer. However, such electroluminescent elements face the problem of durability and do not yet reach the practical level of luminous intensity and durability.

Accordingly, an object of this invention is to provide organic EL elements which excel in both luminous characteristics and reliability and exhibit durability of practical level.

### Disclosure of the Invention

The present inventors have conducted extensive studies, found that the aforementioned problems can be solved by incorporating a specific triphenylamine derivative in the layers of organic compounds of an organic EL element, and completed this invention.

This invention relates to an organic electroluminescent element comprising layers of organic compounds containing at least a luminescent layer interposed between a pair of electrodes at least one of which is transparent or translucent, wherein at least one of said layers of organic compounds comprises a compound represented by the following general formula (1) 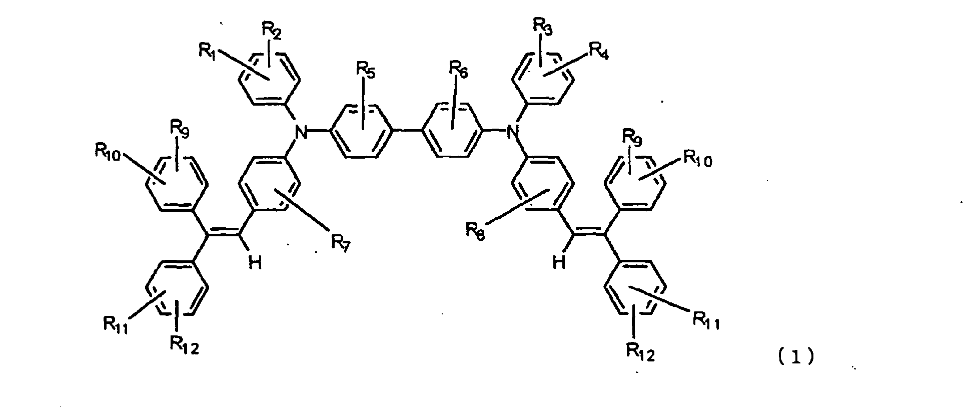 (wherein R₁ to R₁₂ are alkoxy groups, aralkyl groups, alkyl groups with 1 to 6 carbon atoms, aryl groups with 6 to 20 carbon atoms, halogen, nitro groups, cyano groups, or hydrogen, either identical with or different from one another, and R₁ and R₂, R₃ and R₄, R₉ and Rio, and R₁₁ and R₁₂ may respectively join together to form an aromatic ring). This invention further relates to an organic electroluminescent element wherein the luminescent layer constituting the layers of organic compounds comprises a compound represented by the general formula (1) as a luminescent material. This invention still further relates to an organic electroluminescent element wherein the hole injection layer constituting the layers of organic compounds comprises a compound represented by the general formula (1) as a hole transporting material.

This invention will be described in detail below.

In an organic EL element of this invention, a luminescent layer, that is, a layer of organic compound is interposed between a pair of electrodes at least one of which is transparent or translucent. Concretely, the following structures may be cited as examples; however, this invention is not limited to these examples and, if necessary, a light-absorbing diffusion layer and the like may be interposed or a luminescent layer and an electron injection layer may be made into one and the same layer. In general, an organic EL element is formed on a base such as glass in one of the following structures and put to practical use.
Anode/luminescent layer/cathode
Anode/hole injection layer/luminescent layer/cathode
Anode/luminescent layer/electron injection layer/cathode
Anode/hole injection layer/luminescent layer/cathode
Anode/hole injection layer/luminescent layer/electron injection layer/cathode

As mentioned earlier, no specific restriction is imposed on the structure of the layers of organic compounds interposed between a pair of electrodes as long as a compound represented by the general formula (1) is contained in at least one of the layers of organic compounds, be it a luminescent layer alone, a hole injection layer or an electron injection layer, or a luminescent layer and a hole injection layer and/or an electron injection layer. The compound in question is preferably contained in a hole injection layer or a luminescent layer.

In those compounds which are represented by the general formula (1), the substituents R₁ to R₁₂ are substituted or unsubstituted alkyl groups with 1 to 6 carbon atoms such as methyl, ethyl, propyl, and trifluoromethyl, substituted or unsubstituted aryl groups with 6 to 20 carbon atoms such as phenyl, naphthyl, anthryl, and biphenyl, and substituted or unsubstituted alkoxy groups such as methoxy, ethoxy, propoxy, and butoxy. The substituents R₁ and R₂, R₃ and R₄, R₉ and R₁₀, and R₁₁ and R₁₂ may respectively join together to form an aromatic ring and, for example, they may incorporate the benzene ring to which they are linked in the course of ring closure to form a naphthalene ring. Preferably, the substituents R₁ to R₁₂ are hydrogen, unsubstituted alkyl or alkoxy groups with 1 to 6 carbon atoms, aryl groups with 6 to 20 carbon atoms, or aromatic rings resulting from linkage of R₁ and R₂, R₃ and R₄, R₉ and Rio, and R₁₁ and R₁₂.

Compounds represented by the general formula (1) are concretely Compound 1 to Compound 17 shown below, but are not limited to them.

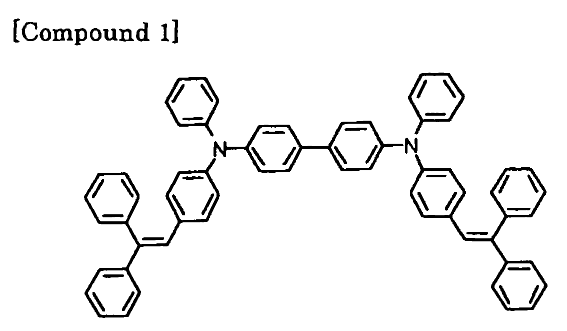

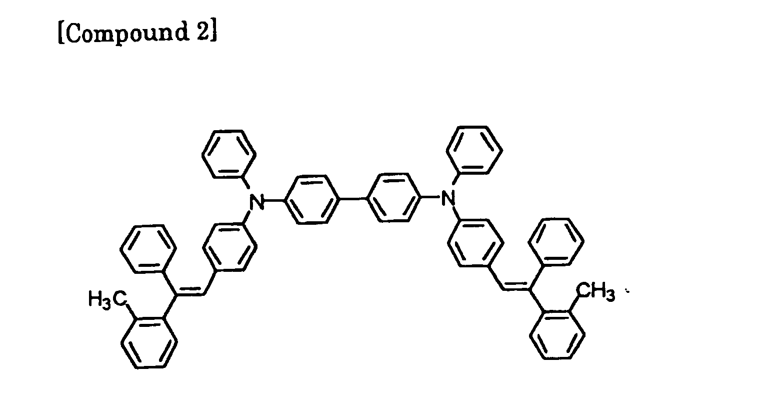

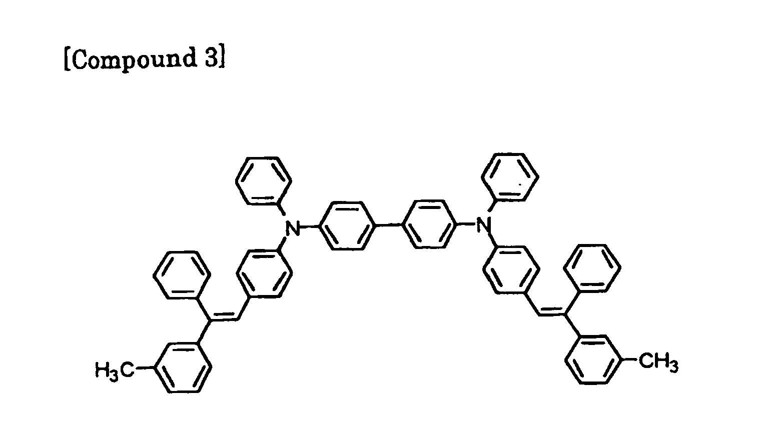

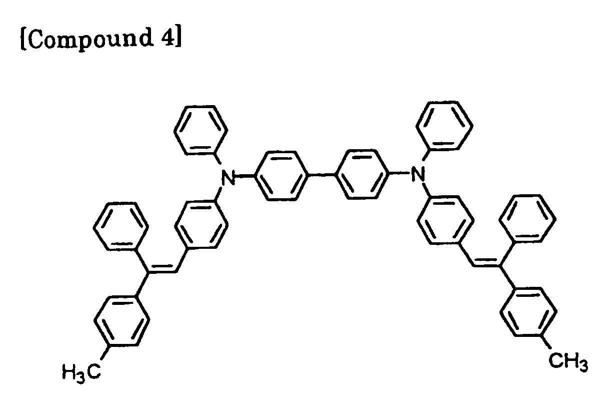

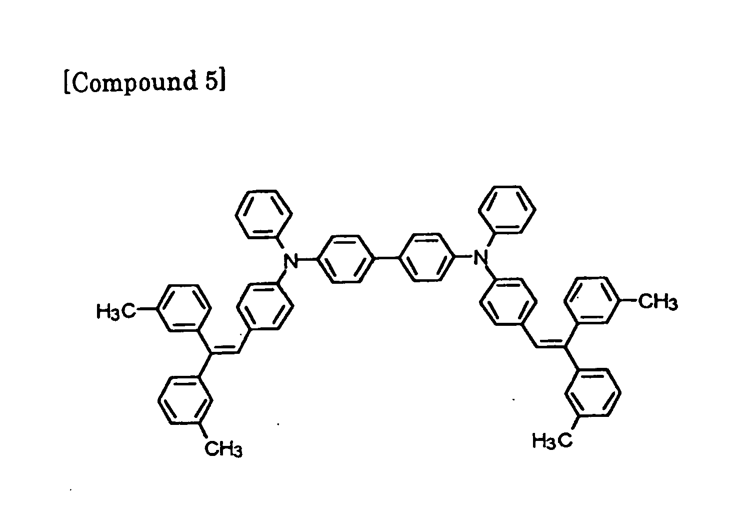

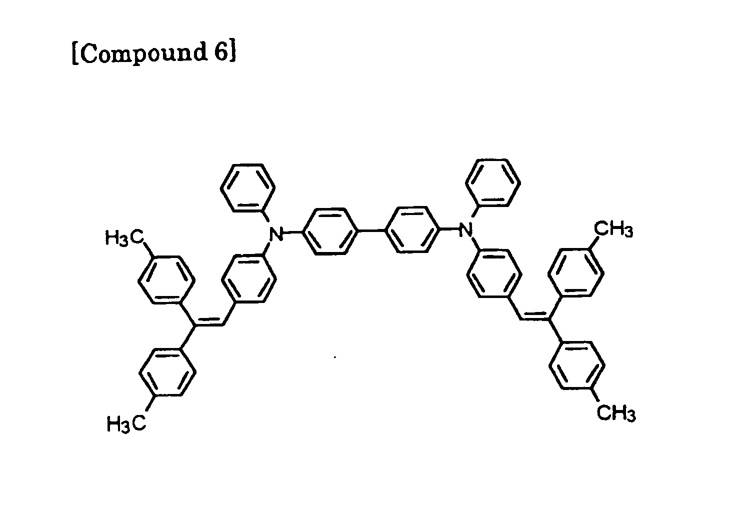

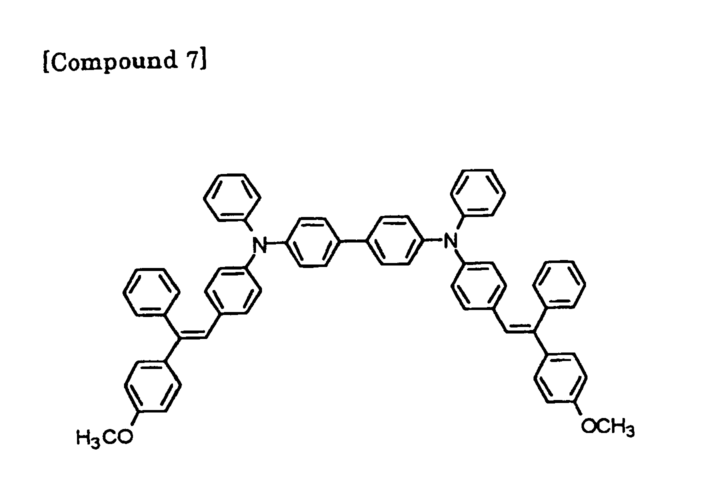

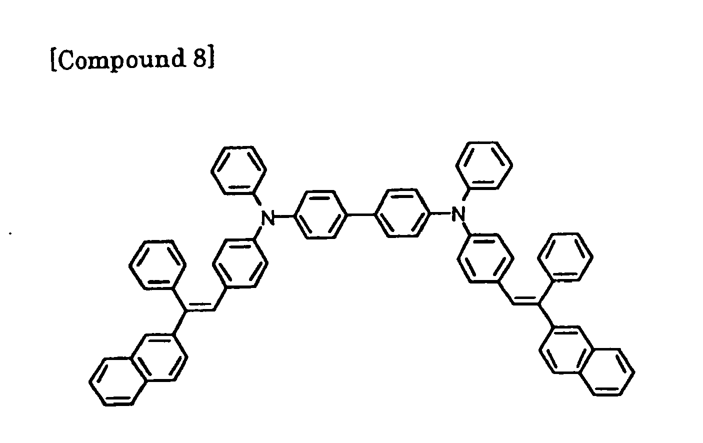

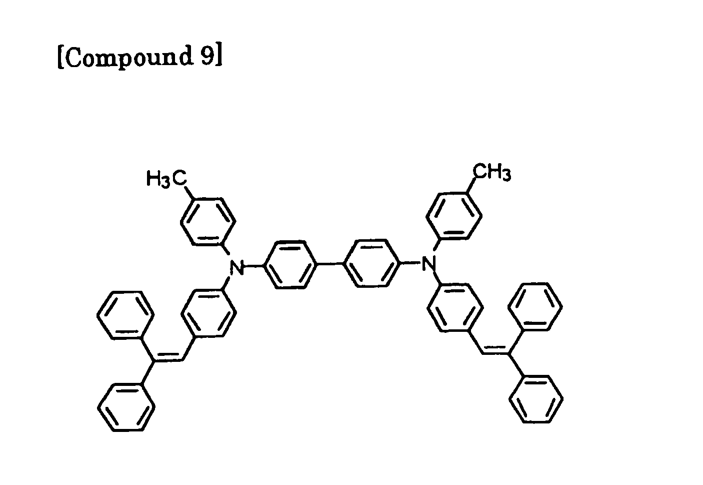

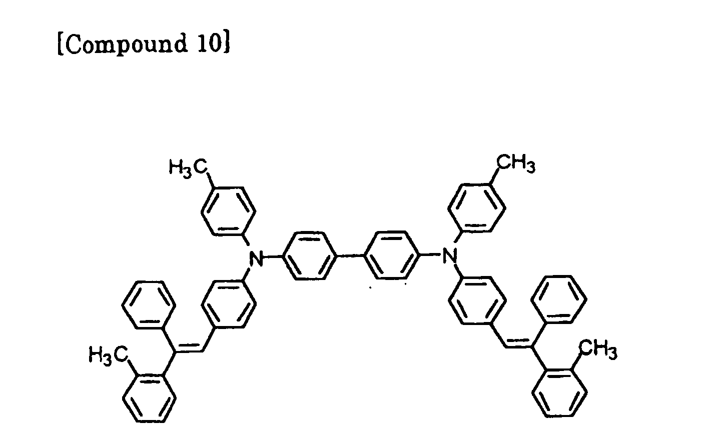

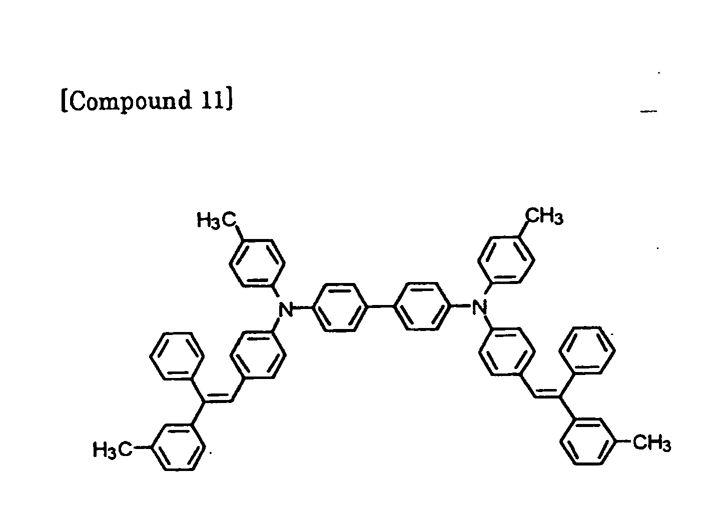

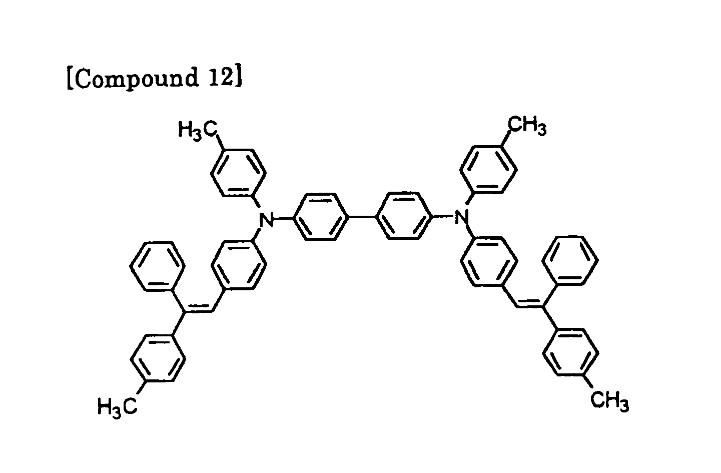

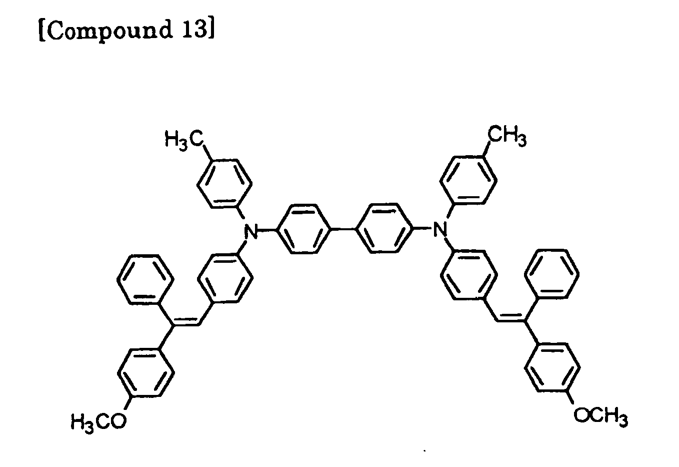

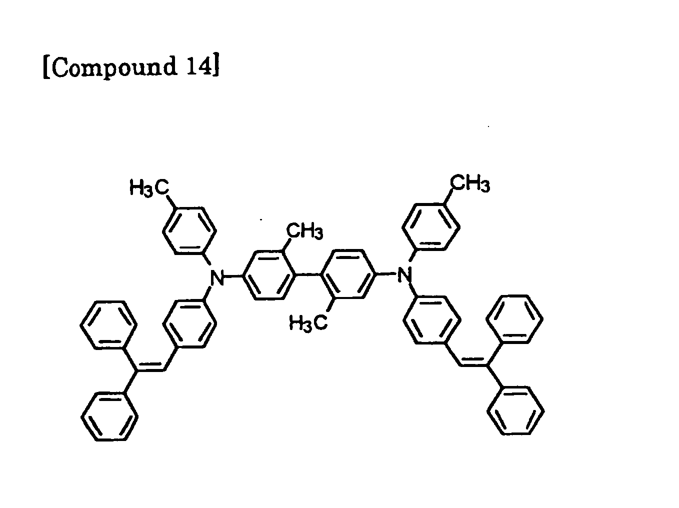

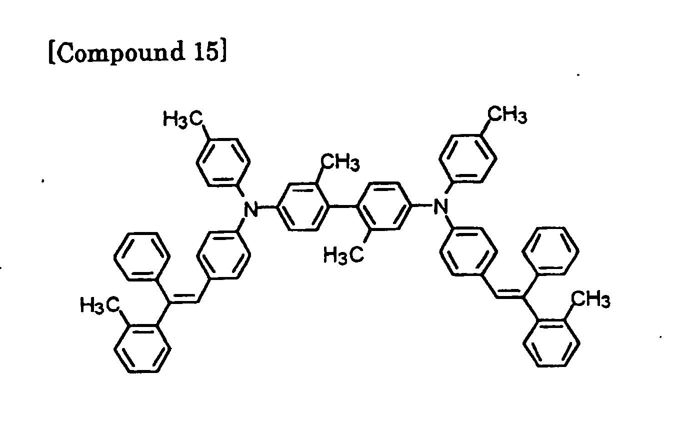

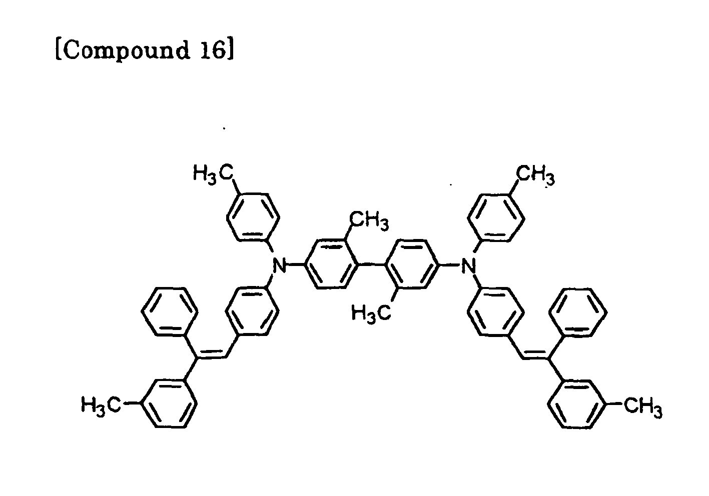

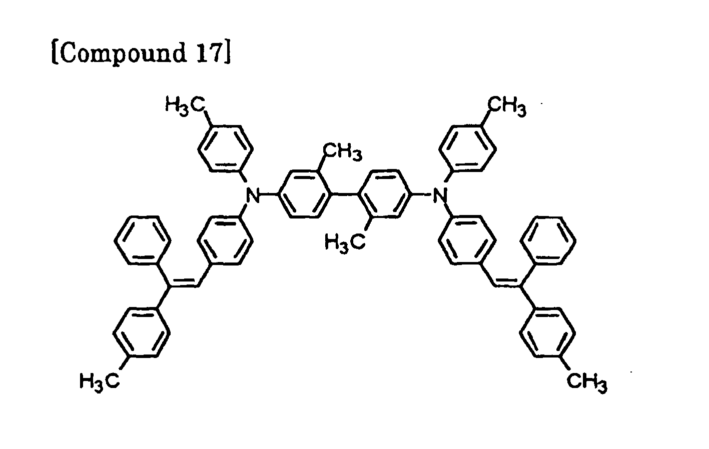

A compound represented by the general formula (1) can be prepared as follows. The Vilsmeier reaction is effected by treating a triphenylamine derivative represented by the following general formula (2) with a methyleneiminium compound (a Vilsmeier complex) formed from phosphoryl chloride and N,N-dimethylformamide (DMF). The resulting dialdehyde represented by the following general formula (4) is then treated with a diarylmethylphosphonic acid derivative represented by the following general formula (4) under the basic conditions to give a compound represented by the general formula (1). In the general formulas (2) to (4), the substituents R₁ to R₁₂ are as defined in the general formula (1) and the substituent R₁₃ designates an alkyl group with 1 to 6 carbon atoms.

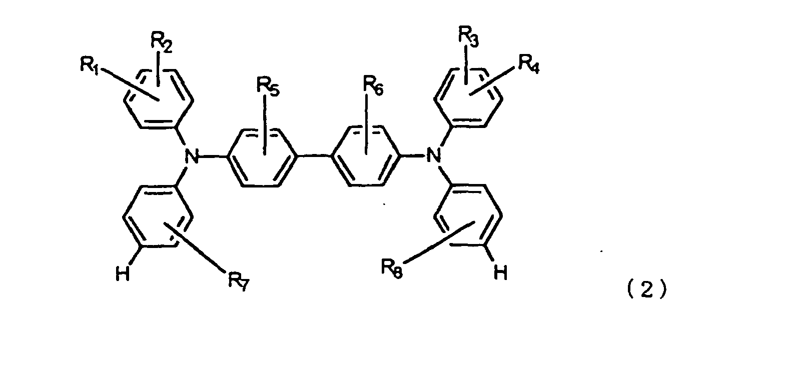

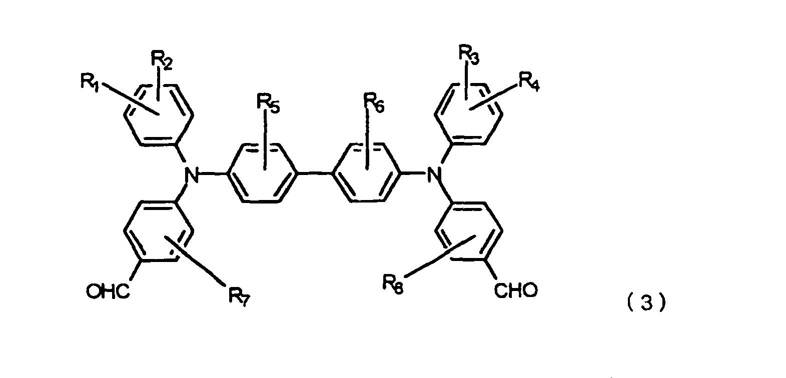

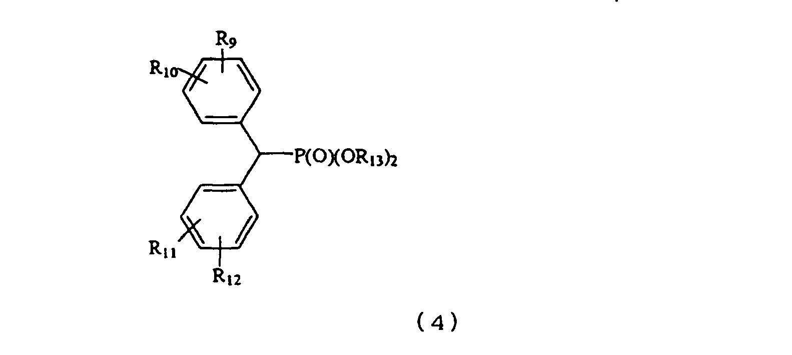

A compound represented by the aforementioned general formula (1) is capable of emitting light of high luminance at low voltage and is suitable as a luminescent material for organic EL elements; besides, it has a good ability to transport holes as well as electrons and is suitable as hole and electron transporting materials for organic EL elements. In addition, because of its good heat resistance, a compound represented by the general formula (1) can improve the durability of organic EL elements markedly in case it is used in the layers of organic compounds. In addition to organic EL elements, the compound in question can be used as a charge transporting agent in a photosensitive element for electrophotography because of its good hole transporting ability.

In an organic El element of this invention, the luminescent layer, the hole injection layer, and the electron injection layer, together constituting the layers of organic compounds, are usually formed by such methods as vapor deposition, spin coating, and casting and the thickness of these layers is preferably 10-1,000 nm, more preferably 20-200 nm.

In this invention, an organic EL element comprising layers of organic compounds interposed between a pair of electrodes is usually formed on a suitable base. No specific restriction is imposed on the base and materials useful for such base include a plate of glass such as soda-lime glass, nonfluorescent glass, phosphate glass, and silicate glass, a plate of quartz, a plate of plastics such as acrylic resin, polyethylene, polyester, and silicone, a film of plastics, and a foil of a metal.

The materials useful for the anode include metals, alloys, electrically conductive compounds, and mixtures thereof, all with a large work function. Concrete examples are a metal such as gold and the like, CuI, indium tin oxide (ITO), SnO₂, and ZnO. The materials useful for the cathode include metals, alloys, electrically conductive compounds, and mixtures thereof, all with a small work function. Concrete examples are Na, Na-K alloys, Mg, Li, Mg-Ag alloys, Al/AlO₂, In, and rare earth metals.

At least one of the aforementioned electrodes needs to be transparent or translucent in order to take out light and the transmission on the side for taking out light is preferably more than 10%. The sheet resistance as electrode is preferably 100 Ω/ □ or less.

The materials useful for the organic luminescent layer include, in addition to compounds represented by the general formula (1), aromatic compounds such as tetraphenylbutadiene, metal complexes such as 8-hydroxyquinoline-aluminum complex, cyclopentadiene derivatives, perinone derivatives, oxadiol derivatives, bisstyrylbenzene derivatives, perylene derivatives, coumarin compounds, rare earth complexes, distyrylpyrazine derivatives, p-phenylene compounds, thiadiazolopyridine derivatives, pyrrolopyridine derivatives, and naphthyridine derivatives.

The materials useful for the hole injection layer include, in addition to compounds represented by the general formula (1), triazole compounds, oxadiazole derivatives, imidazole derivatives, polyarylalkanes, pyrazoline derivatives, pyrazolone derivatives, phenylenediamine derivatives, arylamines, oxazole derivatives, styrylanthracene derivatives, fluorene derivatives, hydrazone derivatives, stilbene derivatives, porphyrin derivatives, aromatic tertiary amines, styrylamine compounds, butadiene compounds, polystyrene derivatives, hydrazone derivatives, triphenylmethane derivatives, and tetraphenylbenzidine derivatives. Preferable among them are porphyrin compounds, aromatic tertiary amines, and styrylamine compounds.

The materials capable of transporting electrons useful for the electron injection layer include, in addition to compounds represented by the general formula (1), nitro-substituted fluorene derivatives, thiopyran dioxide derivatives, diphenoquinone derivatives, tetracarboxyl-substituted perylene derivatives, anthraquinodimethan derivatives, fluorenylidenemethane derivatives, anthrone derivatives, oxadiazole derivatives, perinone derivatives, and quinoline complexes.

In order to improve the heat resistance of the luminescent layer, the hole injection layer, and the electron injection layer, together constituting the layers of organic compounds, it is allowable to introduce a polymerizable substituent to an organic compound constituting each layer and polymerize the substituent before, during, or after the film formation.

### Brief Description of the Drawing

Fig. 1 is a schematic illustration of an organic electroluminescent element of this invention. In Fig. 1, 1 is a glass base, 2 is an anode (an ITO layer), 3 is a hole injection layer, 4 is a luminescent/electron injection layer, and 5 is a cathode (an AlLi layer).

### Preferred Embodiments of the Invention

A suitable mode of execution of this invention will be described concretely below with reference to synthetic examples, examples, and comparative examples.

### Synthetic Example 1

### Synthesis of Compound 9

To 20.2 g of ice-cooled N,N-dimethylformamide (DMF) was added dropwise 20.1 g of phosphoryl chloride to give a methyleneiminium compound (Vilsmeier complex). To the reaction mixture containing the methyleneiminium compound was added a solution of N,N'-di(p-tolyl)-N,N'-diphenylbenzidine in 30 ml of DMF and the reaction was allowed to proceed at 80 °C for 5 hours. Thereafter, the reaction mixture was thrown into ice water and neutralized with an aqueous solution of sodium hydroxide to effect hydrolysis. The precipitate was aged, filtered, washed with water, and dried in vacuum to give an ocher-colored powder. The powder was purified by silica gel chromatography to give 4.1 g of N,N'-bis(4-formylphenyl)-N,N'-di(p-tolyl)benzidine [Compound 18].

The NMR and mass spectra of Compound 18 were measured and the results were as follows.

¹H NMR (400 MHz, CDCl₃, 27 °C): 2.37, s, 6H; 7.05, d, 4H (J = 8.5 Hz); 7.11, d, 4H (J = 8.3 Hz); 7.18, d, 4H (J = 8.3 Hz); 7.22, d, 4H (J = 8.5 Hz); 7.53, d, 4H (J = 8.8 Hz); 7.69, d, 4H (J = 8.8 Hz); 9.81, s, 2H

MS: m/z 572 (M⁺)

Then, 5.7 g of Compound 18 and 6.1 g of dimethyl diphenylmethylphosphonate [Ph₂CH-PO(OCH₃)₂] were dissolved in 50 ml of DMF and cooled to a temperature below 10°C. To this mixture was added a solution of 3.0 g of potassium t-butoxide in 50 ml of DMF at the temperature below 10°C, the ice bath was removed, and the mixture was stirred at room temperature for 4 hours. The reaction mixture was thrown into ice water and the precipitate was filtered, washed with water, dried in vacuum, and purified by silica gel chromatography to give 4.4 g of N,N'-bis[4-(2,2-diphenylethenyl)phenyl]-N,N'-di(p-tolyl)benzidine [Compound 9].

The NMR and mass spectra of Compound 9 were measured and the results were as follows.

¹H NMR (400 MHz, CDCl₃, 27 °C): 2.30, s, 6H; 6.91-6.80, m, 10H; 7.07-6.98, m, 12H; 7.18, d, 4H (J = 8.3 Hz); 7.22, d, 4H (J = 8.5 Hz); 7.53, d, 4H (J = 8.8 Hz); 7.69, d, 4H (J = 8.8 Hz); 9.81, s, 2H

MS: m/z 872 (M⁺-1)

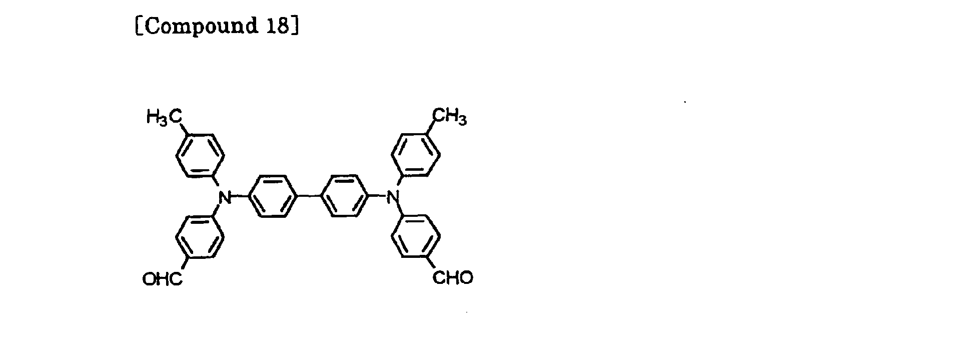

### Synthetic Example 2

### Synthesis of Compound 11

In 30 ml of DMF were dissolved 1.4 g of Compound 18 and 2.4 g of diethyl 1-phenyl-1-(m-tolyl)methylphosphonate [Ph(m-CH₃C₆H₄)CH-PO(OC₂H₅)₂] and cooled to 0 °C. To this mixture was added dropwise a solution of 0.9 g of potassium t-butoxide in 30 ml of DMF at 0 °C, the ice bath was removed, and the mixture was stirred at room temperature for 4 hours. The reaction mixture was thrown into ice water and the precipitate was filtered, washed with water, dried in vacuum, and purified by silica gel chromatography to give N,N'-bis[4-[2-phenyl-2-(m-tolyl)ethenyl]phenyl]-N,N'-di(p-tolyl)benzidine [Compound 11].

The NMR and mass spectra of Compound 11 were measured and the results were as follows.

¹H NMR (400 MHz, CDCl₃, 27 °C): δ 2.31 (s, 9H), 2.33 (s, 3H), 6.79-6.82 (m, 6H), 6.88 (d, J = 10.0 Hz, 4H), 7.00 (d, J = 8.4 Hz, 4H), 7.07 (dd, J = 2.8, 5.2 Hz, 12H), 7.25 (dd, J = 8.4, 2.8 Hz, 6H), 7.30-7.31 (m, 8H), 7.37-7.39 (d, J = 8.4 Hz, 4H)

MS: m/z 900 (M ⁻ -1)

### Synthetic Example 3

### Synthesis of Compound 12

The synthesis of N,N'-bis[4-[2-phenyl-2-(p-tolyl)ethenyl]phenyl] -N,N'-di(p-tolyl)benzidine [Compound 12] was carried out as in Synthetic Example 2 except substituting diethyl 1-phenyl-1-(p-tolyl) methylphosphonate [Ph(p-CH₃C₆H₄)CH-PO(OC₂H₅)₂] for diethyl 1-phenyl-1-(m-tolyl) methylphosphonate.

The NMR and mass spectra of Compound 12 were measured and the results were as follows.

¹H NMR (400 MHz, CDCl₃, 27 °C): δ 2.31 (s, 6H), 2.34 (s, 3H), 2.37 (s, 3H), 6.82 (t, J = 8.0 Hz, 5H), 6.88 (q, J = 3.2 Hz, 3H), 6.91 (s, 1H), 7.00 (m, 3H), 7.05-7.19 (m, 14H), 7.19-7.34 (m, 14H), 7.39 (m, 4H)

MS: m/z 900 (M⁻ -1)

### Synthetic Example 4

### Synthesis of Compound 22

The synthesis of N,N'-bis[4-[2,2-di(p-tolyl)ethenyl]phenyl]-N,N'-di(p-tolyl)benzidine [Compound 22] was carried out as in Synthetic Example 2 except substituting diethyl 1,1-di(p-tolyl)methylphosphonate [(p-CH₃C₆H₄)₂CH-PO(OC₂H₅)₂] for diethyl 1-phenyl-1-(m-tolyl) methylphosphonate.

The NMR and mass spectra of Compound 22 were measured and the results were as follows.

¹H NMR (400 MHz, CDCl₃, 27 °C): δ 2.31 (s, 6H), 2.34 (s, 6H), 2.92 (s, 6H), 6.81-6.84 (m, 6H), 6.88 (ddd, J = 6.4, 2.0, 2.0 Hz, 4H), 7.01 (ddd J = 6.4, 2.0, 2.0 Hz, 4H), 7.04-7.08 (m, 10H), 7.08-7.14 (m, 8H), 7.16-7.23 (m, 5H), 7.25 (s, 1H), 7.35 (ddd, J = 6.4, 2.0, 2.0 Hz, 4H)

MS: m/z 928 (M ⁺ -1)

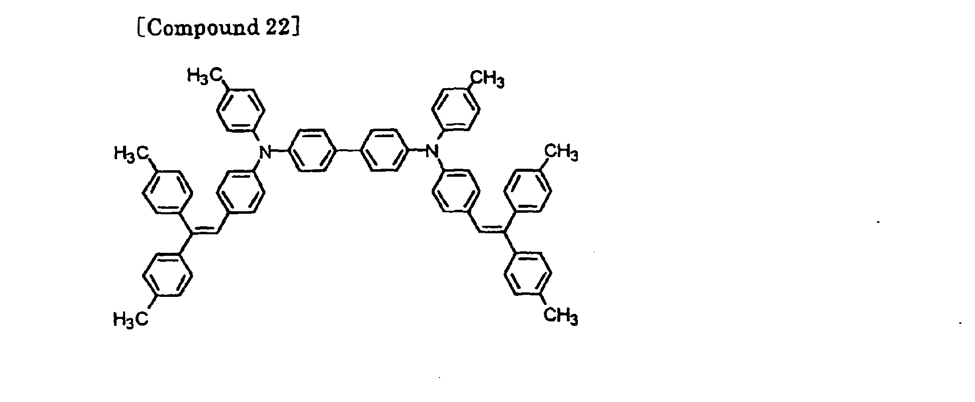

### Synthetic Example 5

### Synthesis of Compound 24

The synthesis of N,N'-bis[4-[2-phenyl-2-(4-phenylphenyl)ethenyl]phenyl] -N,N'-di(p-tolyl)benzidine [Compound 24] was carried out as in Synthetic Example 2 except substituting diethyl 1-phenyl-1-(p-biphenylyl)methylphosphonate [Ph(p-PhC₆H₄)CH-PO(OC₂H₅)₂] for diethyl 1-phenyl-1-(m-tolyl)methylphosphonate.

The NMR and mass spectra of Compound 24 were measured and the results were as follows.

¹H NMR (400 MHz, CDCl₃, 27 °C): δ 2.30 (s, 3H), 2.31 (s, 3H), 6.83-7.07 (m, 21H), 7.25-7.43 (m, 24H), 7.52-7.60 (m, 9H)

MS: m/z 1024 (M⁺-1)

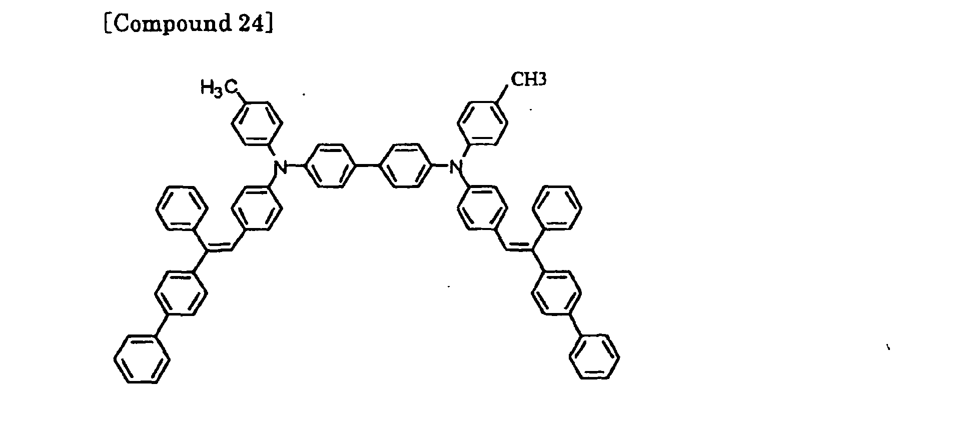

### Example 1

Fig. 1 illustrates schematically the cross section of an organic El element of this invention. The element in question was prepared as follows.

A hole injection layer 3 was formed on a clean anode 2 (an ITO layer 2) provided on a glass base 1 (manufactured by Mikurogiken) and exhibiting a specific resistance of 15 Ω/ □ and an electrode area of 2 × 2 mm² by depositing Compound 9 as a hole transporting material with the aid of a vacuum deposition apparatus of resistance heating type to a film thickness of 500 Å at (2-3) × 10⁻⁷ Torr while controlling the rate of deposition by a film thickness controller of quartz oscillator type manufactured by Arubakku. A luminescent/electron injection layer 4 was formed on the hole injection layer by depositing 8-hydroxyquinoline-aluminum complex (Alq3) as a luminescent material to a film thickness of 500 Å in the same vacuum deposition apparatus without breaking a vacuum. While keeping the vacuum condition, a cathode 5 (or an AlLi layer 5) was formed on the luminescent/electron injection layer by depositing an AlLi alloy (atomic ratio 10:1).

The organic El element thus prepared was confirmed to show the following characteristics when the element was connected to an outside power source and a direct-current voltage was applied to it.
Color of emitted light: Green (light emitted by Alq3 only)
Voltage for starting light emission: +7 V
Maximum luminance: 9,500 cd/m²
Density of driving current at luminance of 1,000 cd/m²: 43 mA/cm²

### Examples 2-5

The organic EL elements shown in Table 1 were prepared as in Example 1 except substituting Compound 11, Compound 12, Compound 22, or Compound 24 for Compound 9 as a hole transporting material. These elements were confirmed to exhibit the characteristics shown in Table 1.

**Table 1**

| Example | Hole transporting material | Color of Emitted light | Voltage for starting light emission (V) | Maximum luminance (cd/m²) | Density of driving current at luminance of 1,000 cd/m² (mA/cm²) |
|---|---|---|---|---|---|
| 2 | Compound 11 | Green | 7 | 3,600 | 50 |
| 3 | Compound 12 | Green | 7 | 5,850 | 43 |
| 4 | Compound 22 | Green | 7 | 4,500 | 48 |
| 5 | Compound 24 | Green | 7 | 4,950 | 46 |

### Examples 6-10 and Comparative Examples 1-2

The aforementioned hole transporting materials were evaluated for their heat resistance as follows. Each of these materials was deposited on a glass base in the manner described in Example 1, the deposited film was stored at a temperature of 20 °C and a humidity of 70%, and the number of days required for the thin film to crystallize was visually determined. For comparison, two known hole transporting materials, TPD and α -PS, were evaluated for their heat resistance. The results are shown in Table 2.

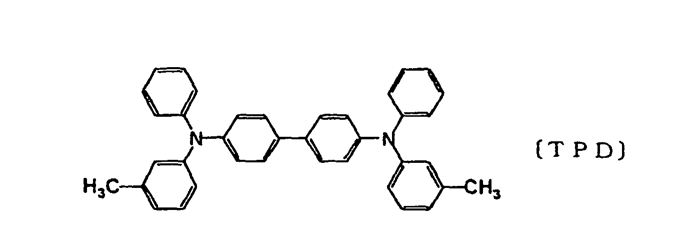

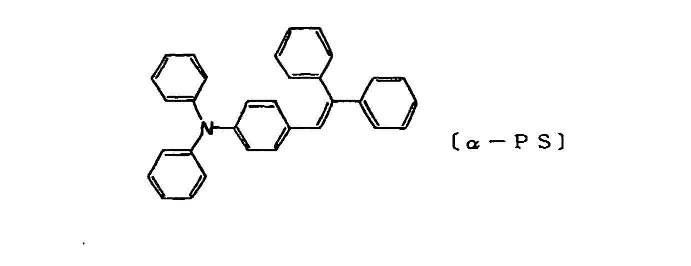

**Table 2**

| | Hole transporting material | Number of days required for crystallization |
|---|---|---|
| Example 6 | Compound 9 | 62 |
| Example 7 | Compound 11 | 58 |
| Example 8 | Compound 12 | 60 |
| Example 9 | Compound 22 | 48 |
| Example 10 | Compound 24 | 60 |
| Comparative example 1 | TPD | 5 |
| Comparative example 2 | α-PS | 3 |

### Example 11

An organic EL element containing Compound 9 as a luminescent material was prepared as follows.

A hole injection layer was formed on a clean ITO electrode with a specific resistance of 15 Ω/ □ and an electrode area of 2 × 2 mm² provided on a glass base (manufactured by Mikurogiken) by depositing TPD as a hole transporting material to a film thickness of 500 Å at (2-3) × 10⁻⁷ Torr with the aid of a vacuum deposition apparatus while controlling the rate of deposition by means of a film thickness controller of quartz oscillator type manufactured by Arubakku. On this layer was formed a luminescent layer by depositing Compound 9 as a luminescent material to a film thickness of 500 Å in the same vacuum deposition apparatus without breaking a vacuum. On this film was formed a cathode by depositing an AlLi alloy (atomic ratio 10:1) while maintaining the vacuum condition. The organic EL element thus prepared was confirmed to emit light with the following characteristics when it was connected to an outside power source and direct-current voltage was applied to it.
Color of emitted light: Bluish green
Voltage for starting light emission: +13 V
Maximum luminance: 25 cd/m²

### Industrial Applicability

Organic electroluminescent elements of this invention possess excellent characteristics with respect to luminous intensity and durability and are useful as luminescent elements in a variety of displays.

## Claims

1. An organic electroluminescent element comprising layers of organic compounds containing at least a luminescent layer interposed between a pair of electrodes at least one of which is transparent or translucent, wherein at least one of said layers of organic compounds comprises a compound represented by the following general formula (1) 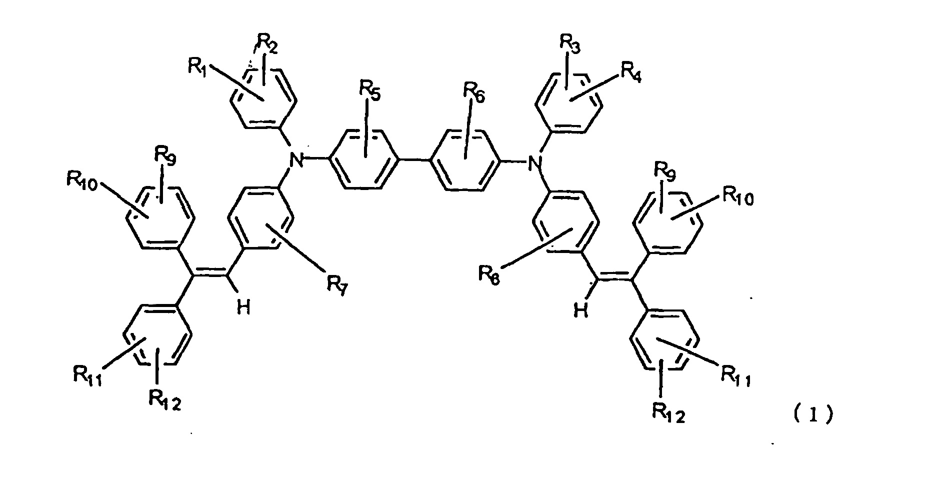 (wherein R₁ to R₁₂ designate alkoxy, aralkyl, alkyl with 1 to 6 carbon atoms, aryl with 6 to 20 carbon atoms, halogen, nitro, cyano, or hydrogen, R₁ to R₁₂ are either identical with or different from one another, and R₁ and R₂, R₃ and R₄, R₉ and R₁₀, and R₁₁ and R₁₂ may respectively join together to form an aromatic ring).

2. An organic electroluminescent element as claimed in claim 1 wherein said layers of organic compounds are selected from the group comprising: a luminescent layer; a hole injection layer and a luminescent layer; a luminescent layer and an electron injection layer; and a hole injection layer, a luminescent layer and an electron injection layer.

3. An organic electroluminescent element as claimed in claim 1 or claim 2 wherein said compound represented by the formula (1) is contained in a luminescent layer alone, a hole injection layer or an electron injection layer, or a luminescent layer and a hole injection layer and/or an electron injection layer.

4. An organic electroluminescent element as claimed in claim 1 or claim 2 wherein said compound represented by the formula (1) is contained in a hole injection layer or a luminescent layer.

5. An organic electroluminescent element as claimed in any preceding claim additionally comprising an interposed light absorbing diffusion layer.

6. An organic electroluminescent element as claimed in any preceding claim wherein a luminescent and an electron injection layer, if both present are one and the same layer.

7. An organic electroluminescent element as claimed in any preceding claim wherein said compound of formula (1) is selected from the group comprising the following compounds:

## Patentansprüche

1. Organisches elektrolumineszierendes Element, umfassend Schichten aus organischen Verbindungen, die mindestens eine lumineszente Schicht enthalten, zwischengelagert zwischen einem Paar von Elektroden, von denen mindestens eine transparent oder transluzent ist, wobei mindestens eine der Schichten aus organischen Verbindungen eine Verbindung der folgenden allgemeinen Formel (1) umfasst 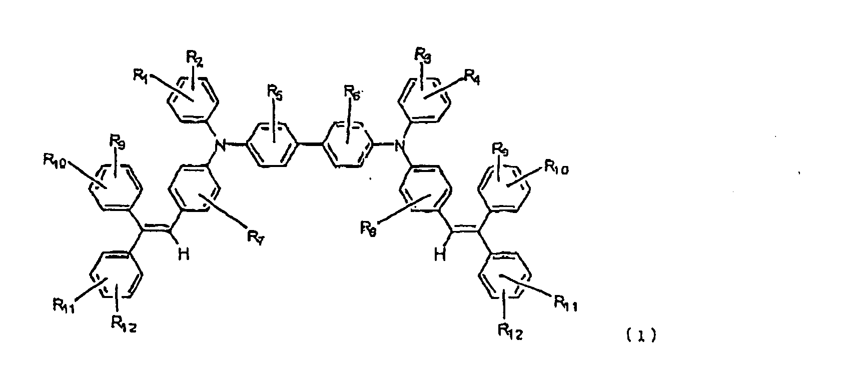 (wobei R₁ bis R₁₂ Alkoxy, Aralkyl, Alkyl mit 1 bis 6 Kohlenstoffatomen, Aryl mit 6 bis 20 Kohlenstoffatomen, Halogen, Nitro, Cyano oder Wasserstoff bedeuten, R₁ bis R₁₂ entweder gleich oder verschieden voneinander sind, und R₁ und R₂, R₃ und R₄, R₉ und R₁₀, und R₁₁ und R₁₂ jeweils verbunden sein können, um einen aromatischen Ring zu bilden).

2. Organisches elektrolumineszierendes Element nach Anspruch 1, wobei die Schichten aus organischen Verbindungen ausgewählt sind aus der Gruppe umfassend: eine lumineszente Schicht; eine Lochinjektionsschicht und eine lumineszente Schicht; eine lumineszente Schicht und eine Elektroneninjektionsschicht; und eine Lochinjektionsschicht, eine lumineszente Schicht und eine Elektroneninjektionsschicht.

3. Organisches elektrolumineszierendes Element nach Anspruch 1 oder Anspruch 2, wobei die Verbindung der Formel (1) in nur einer lumineszenten Schicht, in einer Lochinjektionsschicht oder einer Elektroneninjektionsschicht, oder in einer lumineszenten Schicht und einer Lochinjektionsschicht und/oder einer Elektroneninjektionsschicht enthalten ist.

4. Organisches elektrolumineszierendes Element nach Anspruch 1 oder Anspruch 2, wobei die Verbindung der Formel (1) in einer Lochinjektionsschicht oder einer lumineszenten Schicht enthalten ist.

5. Organisches elektrolumineszierendes Element nach einem der vorstehenden Ansprüche, ferner umfassend eine zwischengelagerte lichtabsorbierende Diffusionsschicht.

6. Organisches elektrolumineszierendes Element nach einem der vorstehenden Ansprüche, wobei eine lumineszente und eine Elektroneninjektionsschicht, falls beide vorhanden sind, ein und dieselbe Schicht sind.

7. Organisches elektrolumineszierendes Element nach einem der vorstehenden Ansprüche, wobei die Verbindung der Formel (1) ausgewählt ist aus der Gruppe umfassend die folgenden Verbindungen:

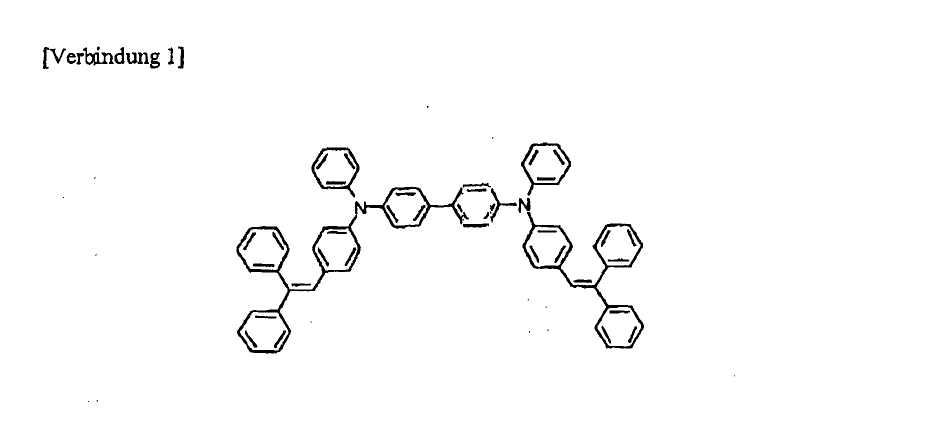

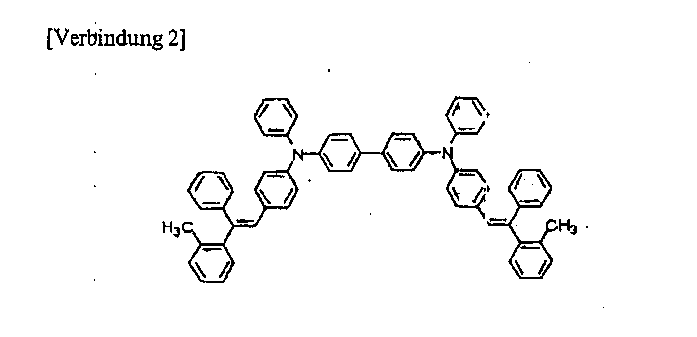

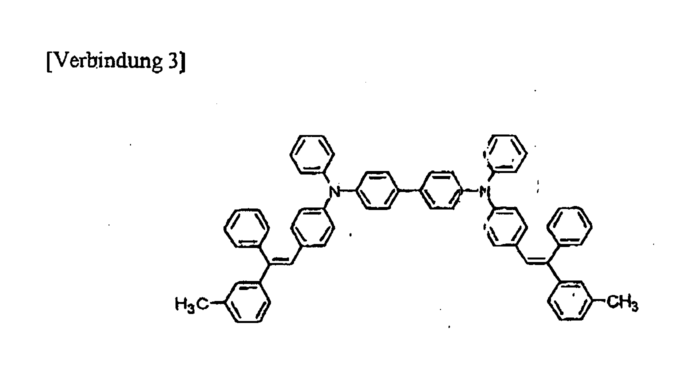

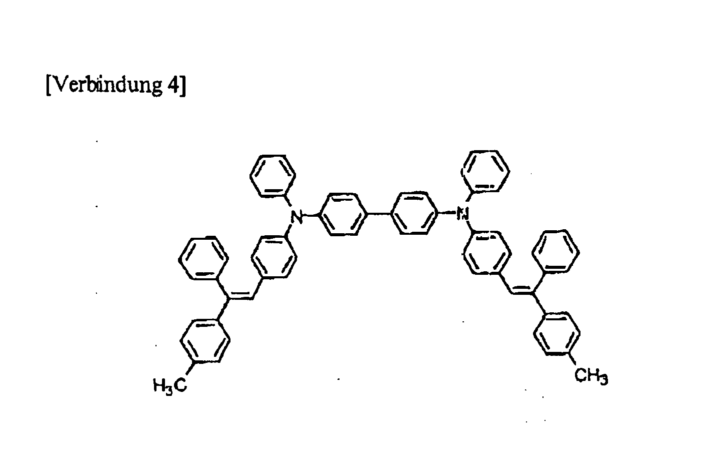

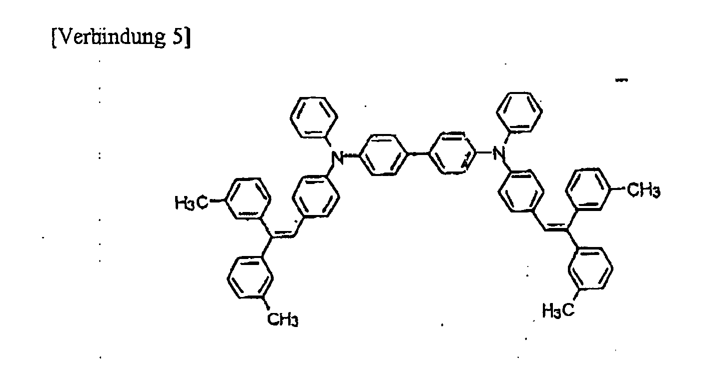

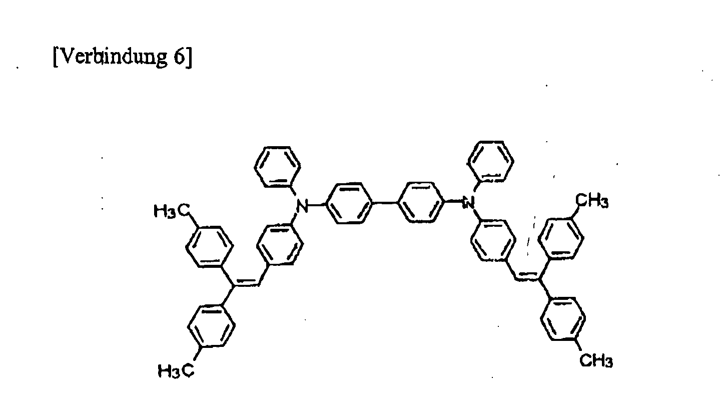

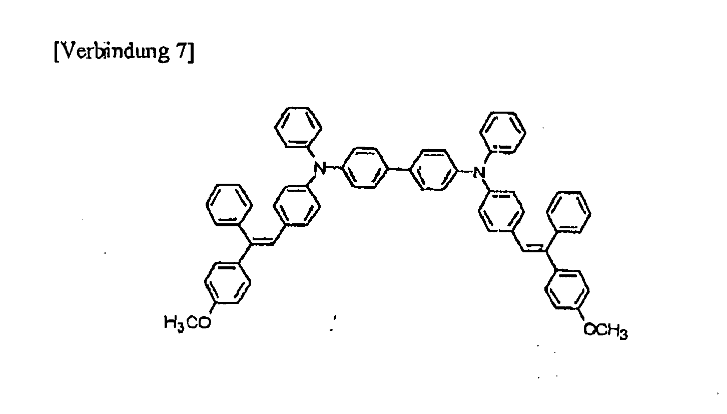

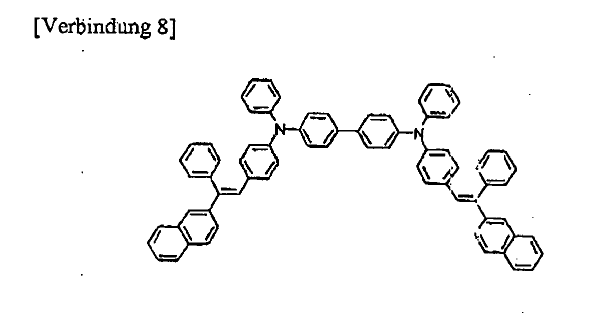

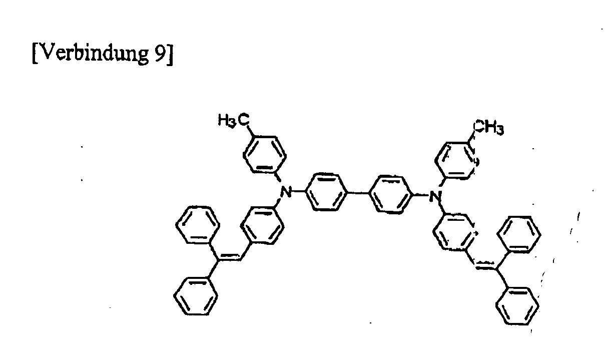

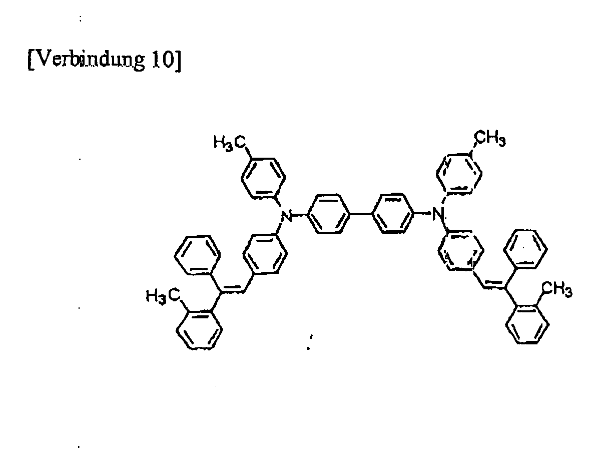

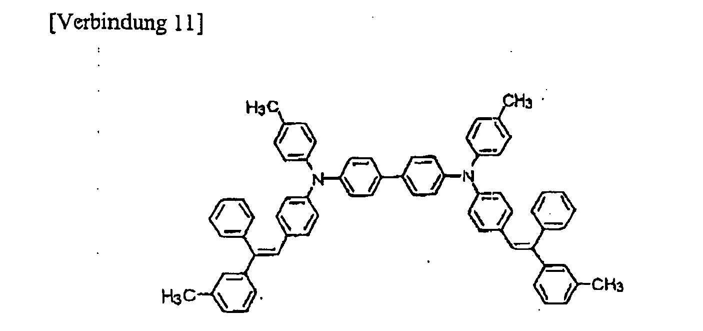

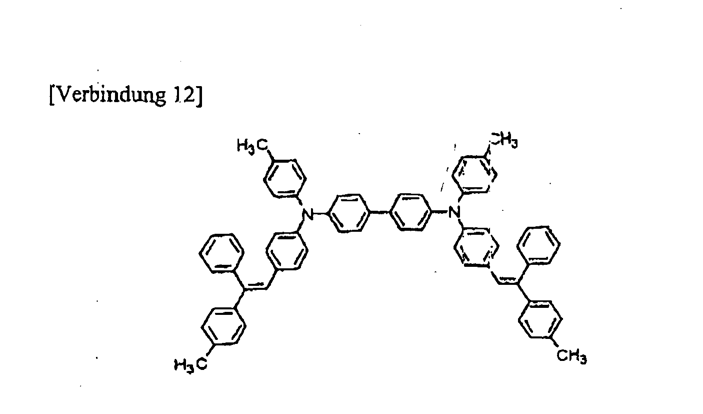

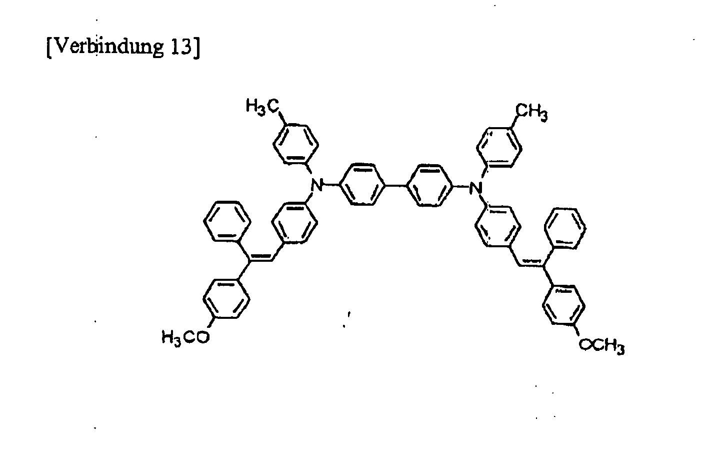

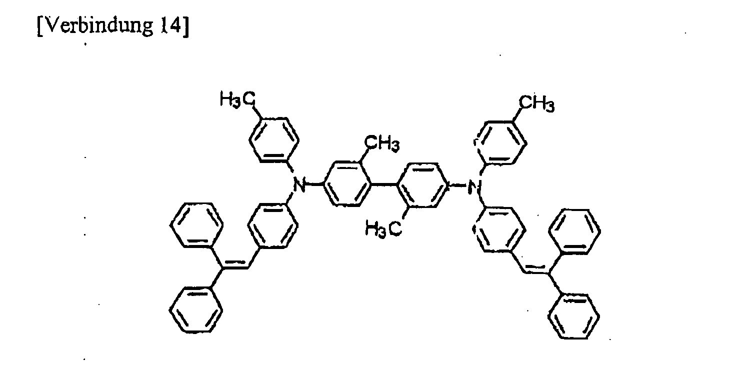

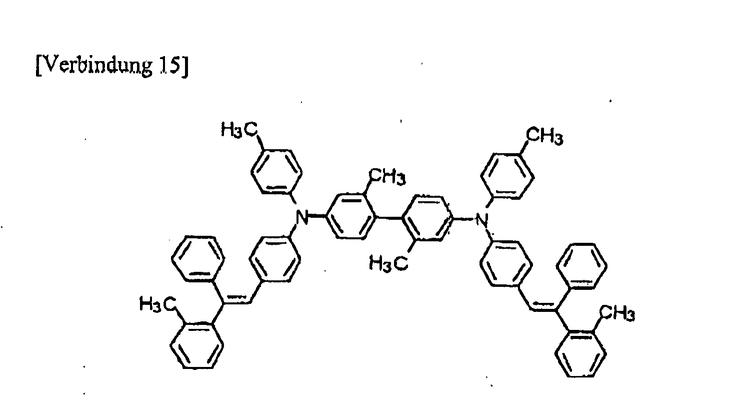

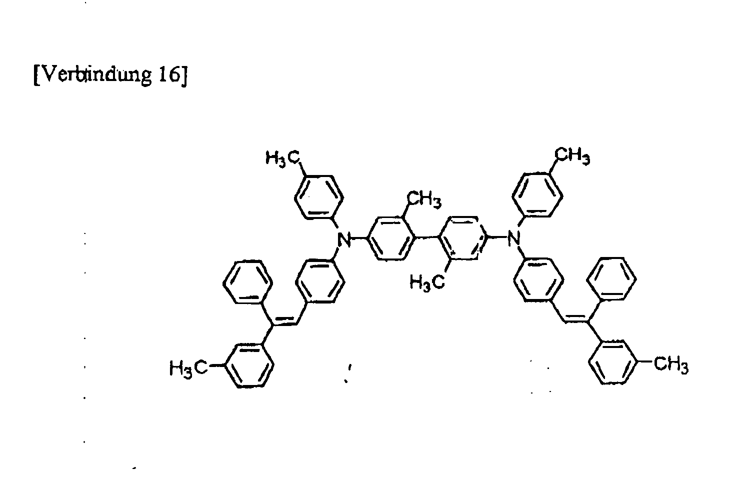

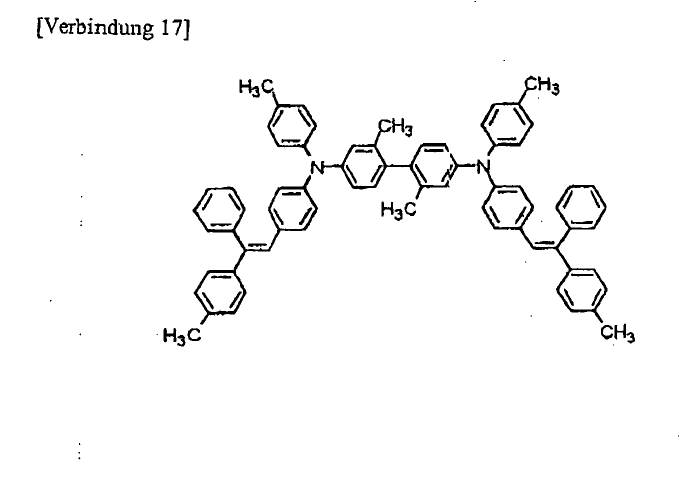

## Revendications

1. Elément électroluminescent organique comprenant des couches de composés organiques contenant au moins une couche luminescente interposée entre une paire d'électrodes dont au moins une est transparente ou translucide, dans lequel au moins une desdites couches de composés organiques comprend un composé représenté par la formule générale (1) suivante 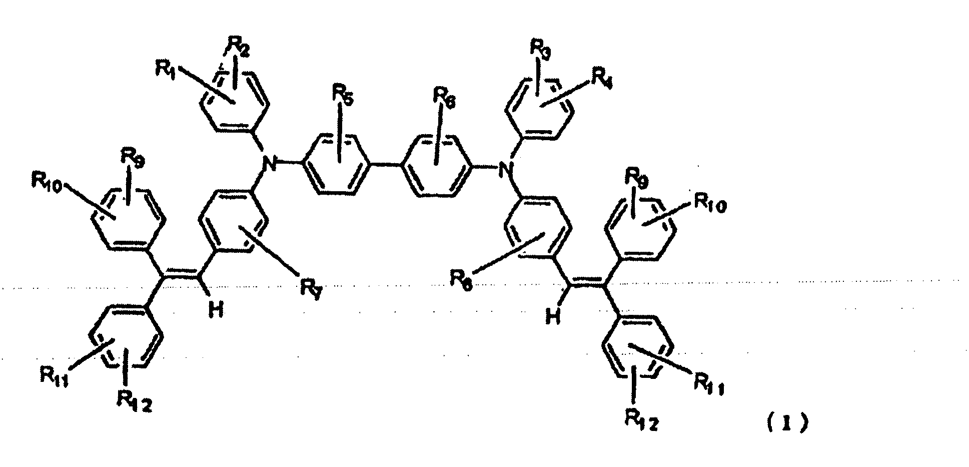 (dans laquelle R₁ à R₁₂ désignent un groupe alcoxy, aralkyle, alkyle avec 1 à 6 atomes de carbone, aryle avec 6 à 20 atomes de carbone, halogène, nitro, cyano ou un atome d'hydrogène, R₁ à R₁₂ sont soit identiques soit différents les uns des autres, et R₁ et R₂, R₃ et R₄, R₉ et R₁₀, et R₁₁ et R₁₂ peuvent respectivement se joindre ensemble pour former un cycle aromatique).

2. Elément électroluminescent organique selon la revendication 1, dans lequel lesdites couches de composés organiques sont choisies parmi le groupe comprenant : une couche luminescente ; une couche d'injection de trous et une couche luminescente ; une couche luminescente et une couche d'injection d'électrons ; et une couche d'injection de trous, une couche luminescente et une couche d'injection d'électrons.

3. Elément électroluminescent organique selon la revendication 1 ou la revendication 2, dans lequel ledit composé représenté par la formule (1) est contenu dans une couche luminescente seule, une couche d'injection de trous ou une couche d'injection d'électrons, ou une couche luminescente et une couche d'injection de trous et/ou une couche d'injection d'électrons.

4. Elément électroluminescent organique selon la revendication 1 ou la revendication 2, dans lequel ledit composé représenté par la formule (1) est contenu dans une couche d'injection de trous ou une couche luminescente.

5. Elément électroluminescent organique selon l'une des revendications précédentes, comprenant de plus une couche de diffusion interposée absorbant la lumière.

6. Elément électroluminescent organique selon l'une des revendications précédentes, dans lequel une couche électroluminescente et une couche d'injection d'électrons, si toutes deux sont présentes, sont une seule et même couche.

7. Elément électroluminescent organique selon l'une des revendications précédentes, dans lequel ledit composé de formule (1) est choisi parmi le groupe comprenant les composés suivants :
